# EUROPEAN PATENT APPLICATION

(11) **EP 2 019 419 A1**
(43) Date of publication of application: **28.01.2009**
(21) Application number: 07743725.9
(22) Date of filing: 14.05.2007
(51) Int. Cl.: H01L 21/304, B24B 37/00, C09K 3/14

(54) **METHOD FOR PRODUCING POLISHING COMPOSITION**

(30) Priority: 16.05.2006 JP 2006136524
(71) Applicant: Showa Denko K.K., Tokyo 105-8518 (JP)
(72) Inventor: SATO, Takashi, c/o Shiojiri Plant SHOWA DENKO K.K., Shiojiri-shi, Nagano; 399-6461 (JP); TAKAHASHI, Hiroshi, c/o Shiojiri Plant SHOWA DENKO K.K., Shiojiri-shi, Nagano; 399-6461 (JP); SHIMAZU, Yoshitomo, c/o Shiojiri Plant SHOWA DENKO K.K., Shiojiri-shi, Nagano; 399-6461 (JP); ITO, Yuji, c/o Shiojiri Plant SHOWA DENKO K.K., Shiojiri-shi, Nagano; 399-6461 (JP)
(74) Representative: Strehl, Peter
(86) International application number: PCT/JP2007/060290
(87) International publication number: WO 2007/132933

(57) **Abstract**

The present invention provides a method for producing an abrasive composition, which can control dishing, a method for polishing a substrate using the abrasive composition, and a method for producing a substrate. In the method for producing an abrasive composition, two kinds of preliminary compositions (A) and (B) having different compositions are mixed in different mixing ratios to produce plural kinds of abrasive compositions, wherein a composition containing (a) an abrasive grain, (b) an oxidizing agent, (c) one or more acids selected from the group consisting of amino acids, organic acids and inorganic acids, and (d) a surfactant is used as the preliminary composition (A); and a composition containing (a) an abrasive grain and (b) an oxidizing agent is used as the preliminary composition (B). The preliminary composition (B) may contain the foregoing acid (c) and surfactant (d). In this case, at least one of (a), (b), (c) and (d) in the preliminary composition (A) has a different concentration from that in the preliminary composition (B).

## Description

### TECHNICAL FIELD

The present invention relates to a method for producing an abrasive composition for polishing a substrate, particularly an abrasive composition for polishing a metal portion of a substrate. The present invention also relates to a method for polishing a substrate and a method for producing a substrate, using an abrasive composition produced.

### BACKGROUND ART

Improvement in the working speed and integration scale, for example, rapid development in high performance microprocessors and an increases in the capacity of memory chips, have resulted from progress in technologies in IC (Integrated Circuit) and LSI (Large Scale Integration). Micromachining technologies contribute to the development in high performance. One micromachining technology is a chemical-mechanical polishing method of a planalizing technology. A chemical-mechanical polishing method is used for planalizing an interlayer dielectric film, metal plugs and a wiring metal in a multilayer wiring process.

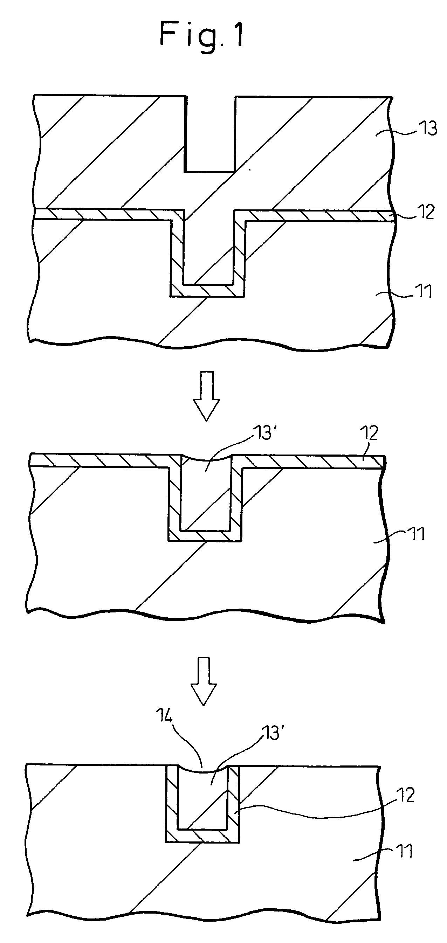

In view of a problem such as a wiring delay, experiments using copper or a copper alloy as the wiring metal has have recently been carried out. Processes for producing wiring using copper or a copper alloy include a damascene process in which a groove is preliminarily formed in an interlayer dielectric film 11 and, if necessary, a thin barrier film 12 of tantalum or tantalum nitride is formed and then a layer 13 of copper or a copper alloy is deposited, as shown in Fig. 1. Since the copper or copper alloy is excessively deposited above the interlayer dielectric film, wiring 13' is formed by polishing to remove excessive copper or copper alloy while planalization is carried out.

As a magnetic recording medium, a Magnestic Random Access Memory (MRAM) has attracted special interest. For MRAMs, there is known a method in which bit writing lines and word writing lines, vertically and laterally crossing a device array to record information on a specific bit of the array, are provided, and selective writing is performed using only an element located at the region where given lines cross each other (for example, see JP 10-116490 A). A metal wiring is formed, the metal wiring being composed of a conductor layer made of aluminum or an aluminum alloy, or copper or a copper alloy, and a ferromagnetic layer made of nickel-iron (permalloy) formed so as to surround the conductor layer. If necessary, a thin barrier film made of tantalum or tantalum nitride is formed so as to sandwich the ferromagnetic layer. The metal wiring is formed by a damascene process, and excessive conductor layer, ferromagnetic layer and barrier film are removed by planarization while polishing.

In view of problems such as an increase in wiring resistance and wiring shorting, dishing 14 (Fig. 1) formed by shaving of a portion of a metal to be polished or erosion is usually lowered as much as possible, during formation of wiring.

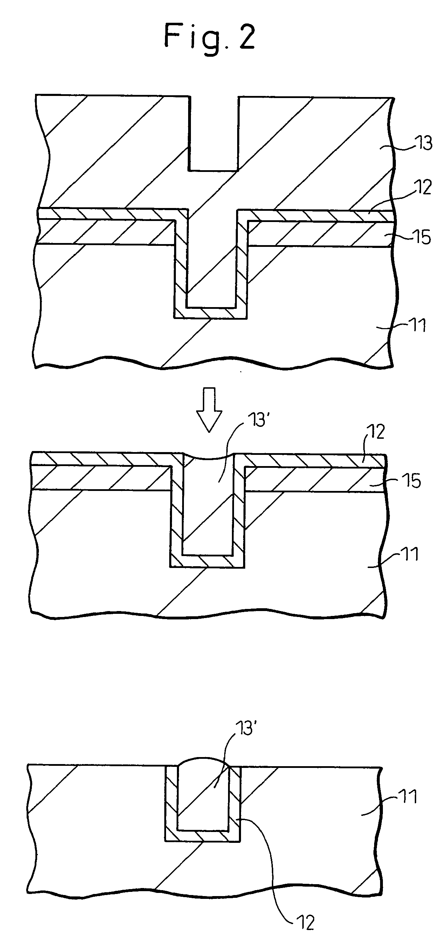

As shown in Fig. 2, a cap layer or anti-reflection film 15 formed before formation of the barrier film 12 may be remained. In that case, since the anti-reflection film or the like has a large thickness, copper wiring 13' is bulged and causes a wiring short after shaving the anti-reflection film by barrier polishing, when dishing is shallow. Therefore, deep dishing is formed during wiring metal polishing so as to prevent the wiring from bulging at the barrier polishing. The thickness of such an anti-reflection film is about several tens of nm and the total thickness of the anti-reflection film and the barrier film is from about 20 to 100 nm. The thickness of the initial layer is locally small and globally large.

In such a case, a polishing method capable of varying the amount of dishing based on wiring conditions is very advantageous.

When the same polishing is performed on many batches, the amount of dishing may vary in each batch due to factors other than an abrasive composition (for example, deterioration of a polishing pad). If it is possible to use an abrasive composition by which the dishing amount is adjusted during each polishing batch so as to negate variations in dishing, consistency in the amount of dishing can be obtained regardless of the polishing batch.

Although metal abrasive compositions include compositions for large dishing and compositions for small dishing, a method capable of obtaining an abrasive composition of controlled dishing simply and easily has never been obtained.

### DISCLOSURE OF THE INVENTION

An object of the present invention is to provide a method for producing an abrasive composition, which can control dishing, a method for polishing a substrate in which a substrate is planarized using this abrasive composition, and a method for producing a substrate, which comprises the step of planalizing using the polishing method. The expression "control dishing" as used herein means that only a dishing amount is adjusted and other characteristics (for example, polishing rate, etc.) do not remarkably vary.

In light of the above problems, the inventors have intensively studied and found that the above object can be achieved by mixing two kinds of abrasive compositions (preliminary compositions), and thus the present invention has been completed.

In other words, the present invention is denoted in the following [1] to [25].
[1] A method for producing plural kinds of abrasive compositions different in dishing amount, for polishing a metal film filled in depressions of a substrate so as to cover the depressions, or a metal film filled in depressions of a substrate having a barrier metal film formed thereon, so as to cover the depressions, which comprises mixing two kinds of preliminary compositions (A) and (B) having different compositions in different mixing ratios to thereby produce the plural kinds of abrasive compositions, wherein a composition containing (a) an abrasive grain, (b) an oxidizing agent, (c) one or more acids selected from the group consisting of amino acids, organic acids and inorganic acids, and (d) a surfactant, is used as the preliminary composition (A); and a composition containing (a) an abrasive grain and (b) an oxidizing agent is used as the preliminary composition (B).
[2] The method for producing plural kinds of abrasive compositions according to the above-described [1], wherein the preliminary composition (B) further contains (c) one or more acids selected from the group consisting of amino acids, organic acids and inorganic acids and (d) a surfactant, and at least one of (a), (b),(c) and (d) in the preliminary composition (A) has a different concentration from that in the preliminary composition (B).
[3] The method for producing plural kinds of abrasive compositions according to the above-described [2], wherein the concentration of the abrasive grain (a) of the preliminary composition (A) is higher than that of the preliminary composition (B).
[4] The method for producing plural kinds of abrasive compositions according to the above-described [2] or [3], wherein the concentration of the oxidizing agent (b) of the preliminary composition (A) is lower than that of the preliminary composition (B).
[5] The method for producing plural kinds of abrasive compositions according to any one of the above-described [2] to [4], wherein the concentration of one or more kinds of acids (c) selected from the group consisting of amino acids, organic acids and inorganic acids of the preliminary composition (A) is lower than that of the preliminary composition (B).
[6] The method for producing plural kinds of abrasive compositions according to any one of the above-described [2] to [5], wherein the concentration of the surfactant (d) of the preliminary composition (A) is higher than that of the preliminary composition (B).
[7] The method for producing plural kinds of abrasive compositions according to any one of the above-described [1] to [6], wherein one or both of the preliminary compositions (A) and (B) further contain an azole group-containing compound having a molecular weight of 300 to 15,000, which has three or more azole groups in the molecule.
[8] The method for producing plural kinds of abrasive compositions according to the above-described [7], wherein both preliminary compositions (A) and (B) contain the azole group-containing compound and the concentration of the azole group-containing compound of the preliminary composition (A) is lower than that of the preliminary composition (B).
[9] The method for producing plural kinds of abrasive compositions according to the above-described [1] to [8], wherein one or both of the preliminary compositions (A) and (B) further contain an anticorrosive agent.
[10] The method for producing plural kinds of abrasive compositions according to the above-described [9], wherein the anticorrosive agent is benzotriazole, tolyltriazole, hydroxybenzotriazole, carboxybenzotriazole, benzimidazole, tetrazole or quinaldic acid.
[11] The method for producing plural kinds of abrasive compositions according to the above-described [9] or [10], wherein both of preliminary compositions (A) and (B) contain the anticorrosive agent and the concentration of the anticorrosive agent of the preliminary composition (A) is higher than that of the preliminary composition (B).
[12] The method for producing plural kinds of abrasive compositions according to any one of the above-described [1] to [11], wherein one or both of the preliminary compositions (A) and (B) further contain an alkali.
[13] The method for producing plural kinds of abrasive compositions according to the above-described [12], wherein the alkali is one or more members selected from the group consisting of ammonia, ethylenediamine and propylenediamine.
[14] The method for producing plural kinds of abrasive compositions according to the above-described [12] or [13], wherein both of preliminary compositions (A) and (B) contain the alkali and the alkali concentration of the preliminary composition (A) is lower than that of the preliminary composition (B).
[15] The method for producing plural kinds of abrasive compositions according to any one of the above-described [1] to [14], wherein the pH of an abrasive composition to be produced is from 5 to 11.
[16] The method for producing plural kinds of abrasive compositions according to any one of the above-described [1] to [15], wherein the surfactant is one or more members selected from the group consisting of alkylaromatic sulfonic acids having 8 or more carbon atoms, phosphate esters having an alkyl group of 8 or more carbon atoms and fatty acids having an alkyl group of 8 or more carbon atoms.
[17] The method for producing plural kinds of abrasive compositions according to any one of the above-described [1] to [16], wherein the concentration of the abrasive grain (a) is 0.01 to 30% by mass based on the abrasive composition upon polishing.
[18] The method for producing plural kinds of abrasive compositions according to any one of the above-described [1] to [16], wherein the concentration of the oxidizing agent (b) is from 0.01 to 30% by mass based on the abrasive composition upon polishing.
[19] The method for producing plural kinds of abrasive compositions according to any one of the above-described [1] to [16], wherein the concentration of the acid (c) is from 0.01 to 10% by mass based on the abrasive composition upon polishing.
[20] The method for producing plural kinds of abrasive compositions according to any one of the above-described [1] to [16], wherein the concentration of the surfactant (d) is 5% by mass or less based on the abrasive composition upon polishing.
[21] A method for polishing a substrate, which comprises producing abrasive compositions by the method according to any one of the above-described [1] to [20] and planarization is performed while adjusting a dishing amount of a substrate by polishing the substrate using the abrasive compositions.
[22] The method for polishing a substrate according to the above-described [21], wherein the temperature of the abrasive composition is from 30°C to 50°C.
[23] The method for polishing a substrate according to the above-described [21] or [22], wherein the metal film is made of copper or a copper-containing alloy.
[24] The method for polishing a substrate according to any one of the above-described [21] to [23], wherein the barrier metal film is made of tantalum or a tantalum alloy.
[25] A method for producing a substrate having a dishing amount within a range from 1 to 300 nm, which comprises the step of polishing a substrate by the polishing method according to any one of the above-described [21] to [24].

According to the present invention, since dishing can be controlled by polishing using a combination of two kinds of preliminary compositions, it becomes possible to produce a substrate without using plural metal abrasive compositions for exclusive use when one process for manufacturing IC chips includes plural planarization steps.

Furthermore, even when different kinds of IC chips are required, the two kinds of preliminary compositions can be used and it becomes easy to produce a substrate without changing metal abrasive compositions, polishing pads and polishing machines.

### BRIEF DESCRIPTION OF THE DRAWINGS

Fig. 1 is a cross-sectional view explaining a method for producing wiring using copper or a copper alloy.
Fig. 2 is a cross-sectional view explaining a method for producing wiring using copper or a copper alloy when an anti-reflection film is remained.
Fig. 3 is a cross-sectional view explaining dishing.

### BEST MODE FOR CARRYING OUT THE INVENTION

Embodiments of the present invention will be described in detail.

The present invention is a method for producing plural kinds of abrasive compositions which provide different amounts of dishing, for polishing a metal film filled in depressions of a substrate so as to flatten the depressions, or a metal film filled in depressions of a substrate having a barrier metal film formed thereon, so as to flatten the depressions, wherein two kinds of preliminary compositions having different compositions are mixed in different ratios to produce the plural kinds of abrasive compositions, in such a manner that the abrasive compositions give predetermined dishing amounts within, for example, a range from 1 to 300 nm.

As the two kinds of preliminary compositions, a preliminary composition (A) containing (a) an abrasive grain, (b) an oxidizing agent, (c) one or more acids selected from the group consisting of amino acids, organic acids and inorganic acids, and (d) a surfactant, and a preliminary composition (B) containing (a) an abrasive grain and (b) an oxidizing agent can be used.

The preliminary composition (B) may further contain (c) one or more acids selected from the group consisting of amino acids, organic acids and inorganic acids, and (d) a surfactant. In this case, at least one of (a), (b), (c) and (d) in the preliminary composition (A) has a different concentration from that in the preliminary composition (B).

The preliminary compositions (A) and (B) can be mixed in any mixing ratio (i.e., a mixing ratio in which the percentage of one preliminary composition is more than 0% and less than 100% (while the percentage of the other preliminary mixture is less than 100% and more than 0% accordingly) in a final abrasive composition prepared by mixing the two) so as to give a predetermined dishing amount within a range from 1 to 300 nm.

When an abrasive composition is produced by the present invention, the kinds of components having the same function can be different between two preliminary mixtures. For example, an abrasive grain contained in one preliminary mixture may be different from an abrasive grain contained in the other preliminary mixture.

Components used in each preliminary composition will be explained below.

### (Abrasive Grain)

In the present invention, an abrasive such as a silica, alumina, ceria or organic abrasive can be used as the abrasive grain. One or more abrasives may be used. Although the abrasive is used for the purpose of sufficiently increasing a polishing rate, some abrasive may cause defects such as scratch on a surface of a substrate. Silica is an example of a preferred abrasive capable of suppressing formation of defects while sufficiently increasing a polishing rate. A more preferred abrasive is an abrasive containing, as a main component, colloidal silica produced by hydrolysis of an alkoxysilane. The content of the abrasive may be from 0.01 to 30% by mass, preferably from 0.1 to 20% by mass, and more preferably from 0.2 to 10% by mass, based on the abrasive composition upon polishing. When the content of the abrasive is too large, scratch may be formed. In contrast, when the content is too small, it may become impossible to sufficiently increase the polishing rate and a metal film residue on a barrier film may not be removed. The size of the abrasive is preferably 1 µm or less, and more preferably from 0.01 to 0.5 µm, in terms of a particle diameter. When the particle diameter of the abrasive is too small, the polishing rate may not sufficiently increased. In contrast, when the particle diameter of the abrasive is too large, defects such as scratch on a surface of metal may be formed.

### (Oxidizing Agent)

The oxidizing agent used in the present invention contributes to an improvement in a polishing rate as a result of oxidization of metal or a metal alloy. Examples of the oxidizing agent include oxygen; ozone; hydrogen peroxide; alkyl peroxides such as t-butyl hydroperoxide and ethylbenzene hydroperoxide; peroxy acids such as peracetic acid and perbenzoic acid; permanganate such as potassium permanganate; periodates such as potassium periodate; persulfates such as ammonium persulfate and potassium persulfate; hypochlorites such as potassium hypochlorite; and polyoxo acids. The oxidizing agent is preferably hydrogen peroxide or persulfate since it is easy to handle.

The content of the oxidizing agent may be from 0.01 to 30% by mass, preferably from 0.05 to 20% by mass, and more preferably from 0.1 to 10% by mass, based on the abrasive composition upon polishing. When the content of the oxidizing agent is too small, a polishing rate may excessively decrease. In contrast, when the content of the oxidizing agent is too large, the polishing rate may be suppressed.

### (Acid)

The acid selected from the group consisting of inorganic acids, organic acids and amino acids used in the present invention can be added so as to serve as an etching agent thereby promoting polishing and to lead to stable polishing. In the present invention, amino acids are not included in organic acids. Examples of the inorganic acid include sulfuric acid, phosphoric acid, phosphonic acid and nitric acid. Examples of the organic acid include carboxylic acids such as formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid, and salts thereof. Examples of the amino acid include amino acids such as glycine, alanine, β-alanine, 2-aminobutyric acid, norvaline, valine, leucine, norleucine, isoleucine, alloisoleucine, phenylalanine, proline, sarcosine, ornithine, lysine, taurine, serine, threonine, allothreonine, homoserine, tylosin, 3,5-diiodotylosin, β-(3,4-dihydroxyphenyl)alanine, thyroxine, 4-hydroxyproline, cysteine, methionine, ethionine, lanthionine, cystathionine, cystine, cysteic acid, aspartic acid, glutamic acid, S-(carboxymethyl)cysteine, 4-aminobutyric acid, asparagine, glutamine, azaserine, arginine, canavanine, citrulline, δ-hydroxylysine, creatine, kynurenine, histidine, 1-methylhistidine, 3-methylhistidine, ergothioneine and tryptophan.

Such an inorganic acid, organic acid or amino acid may be used alone, or two or more kinds of them may be used in combination. The content of the acid or acids may be from 0.01 to 10% by mass, preferably from 0.02 to 5% by mass, and more preferably from 0.05 to 2% by mass, based on the abrasive composition upon polishing. When the content is too small, it is difficult to obtain a high polishing rate. In contrast, when the content is too large, an etching rate of metal or a metal alloy may increase excessively. It is also possible to adjust dishing by the acid. However, since corrosion may be induced by the acid, the concentration thereof is preferably adjusted so as not to cause corrosion.

### (Surfactant)

One of surfactants, which can be used in the present invention, is an alkylaromatic sulfonic acid having 8 or more carbon atoms. Examples of the alkylaromatic sulfonic acid may include decylbenzenesulfonic acid, undecylbenzenesulfonic acid, dodecylbenzenesulfonic acid, tridecylbenzenesulfonic acid, tetradecylbenzenesulfonic acid, and formalin condensates of alkylbenzenesulfonic acid, alkylnaphthalenesulfonic acid and alkylnaphthalenesulfonic acid, which are mixtures of the above. The alkylaromatic sulfonic acid having 8 or more carbon atoms may be in the form of a potassium or ammonium salt. Among these acids, dodecylbenzenesulfonic acid is preferred. The composition may contain one or more alkylaromatic sulfonic acids having 8 or more carbon atoms. The content of the aromatic sulfonic acid having 8 or more carbon atoms may be 5% by mass or less, preferably 1% by mass or less, and more preferably 0.5% by mass or less, based on the abrasive composition upon polishing. It is considered that the alkylaromatic sulfonic acid having 8 or more carbon atoms contributes to an improvement in step height reduction ratio of a metal film. The addition of the alkylaromatic sulfonic acid having 8 or more carbon atoms contributes to a decrease in dishing.

As the surfactant, a phosphate ester having an alkyl group of 8 or more carbon atoms may be used. Examples of the phosphate ester include alkyl phosphate esters such as octylphosphoric acid, decylphosphoric acid, laurylphosphoric acid, myristylphosphoric acid, cetylphosphoric acid, stearylphosphoric acid, secondary alkyl (average carbon number of 13) phosphoric acid, 2-ethylhexylphosphoric acid and oleylphosphoric acid; and polyoxyalkylene ether alkyl phosphate esters such as monostearyl glyceryletherphosphoric acid, monocetyl glyceryl ether phosphoric acid, monooleyl glyceryl ether phosphoric acid, isostearyl glyceryl ether phosphoric acid, polyoxyethylene octyl ether phosphoric acid, polyoxyethylene decyl ether phosphoric acid, polyoxyethylene lauryl ether phosphoric acid, polyoxyethylene myristyl ether phosphoric acid, polyoxyethylene cetyl ether phosphoric acid, polyoxyethylene stearyl ether phosphoric acid, polyoxyethylene secondary alkyl (average carbon number of 13) ether phosphoric acid, polyoxyethylene 2-methylhexyl ether phosphoric acid, polyoxyethylene 2-oleyl ether phosphoric acid and polyoxyethylene nonyl phenyl ether phosphoric acid. These phosphate esters may be in the form of a potassium or ammonium salt, and may be a primary, secondary or tertiary ester, or a mixture thereof. The surfactant is preferably an alkylphosphoric acid having 8 to 18 carbon atoms, such as octylphosphoric acid, laurylphosphoric acid or stearylphosphoric acid, or a polyoxyalkylene ether phosphate ester such as polyoxyethylene lauryl ether phosphoric acid or polyoxyethylene secondary alkyl (average carbon number of 13) ether phosphoric acid. The surfactant is more preferably a polyoxyalkylene ether phosphate ester having 10 to 15 carbon atoms.

In the present invention, the composition may contain one or more phosphate esters having an alkyl group of 8 or more carbon atoms. The content of the compound may be 5% by mass, preferably 1% by mass or less, and more preferably 0.5% by mass or less, based on the abrasive composition upon polishing. Although such a phosphate ester or polyoxyalkylene ether phosphate ester exerts dishing inhibitory effect, less dishing inhibitory effect is exerted when a small amount of the ester is used. Although dishing can be reduced when a large amount of ester is added, it is difficult to apply in view of performance in practical use when a high polishing rate is required.

As the surfactant, a fatty acid having 8 or more carbon atoms can be further used. When this fatty acid having 8 or more carbon atoms is used alone or in combination with an azole group-containing compound having a molecular weight of 300 to 15,000, which has three or more azole groups in the molecule, roughening of the surface of the metal film during polishing is inhibited. Examples of the fatty acid having 8 or more carbon atoms include saturated fatty acids such as caprylic acid, pelargonic acid, capric acid, lauric acid, myristic acid, pentadecylacid, palmitic acid, margalic acid, stearic acid, arachic acid, behenic acid, lignoceric acid, cerotic acid, montanic acid and melissic acid; and unsaturated fatty acids such as eicosapentaenoic acid, oleic acid, linoleic acid and linolenic acid. The fatty acid may be in the form of a potassium or ammonium salt, and may be used alone or in combination of two or more. Among these, oleic acid is preferred. Oleic acid may be used alone, or a mixture of fatty acids, which contains 50% by mass or more of oleic acid, can also be used. The content of the fatty acid having 8 or more carbon atoms may be 5% by mass or less, preferably 1% by mass or less, and more preferably 0.5% by mass or less, in terms of the concentration upon polishing. Since metal film residue may be formed on the barrier film when the content of the fatty acid is too large, the content may be a minimum content which enables a sufficient decrease in surface rougheness of the metal film.

In addition to the above surfactant, any of cationic, anionic and nonionic surfactants can be used as another surfactant. Examples of the cationic surfactant include aliphatic amines or salts thereof, and aliphatic ammonium salts. Examples of the anionic surfactant include alkylethercarboxylic acids or salts thereof, and sulfate ester compounds such as higher alcohol sulfate esters, alkylethersulfuric acids or salts thereof. Examples of the nonionic surfactant include ether type surfactants such as polyoxyethylene alkyl ether, ether ester type surfactants such as polyoxyethylene ethers of glycerin esters, and ester type surfactants such as polyethylene glycol fatty acid esters, glycerin esters and sorbitan esters.

To the abrasive composition of the present invention, a water-soluble polymer can also be added. Examples of the water-soluble polymer include polyacrylic acid, polymethacrylic acid or ammonium salts thereof, polyisopropylacrylamide, polydimethylacrylamide, polymethacrylamide, polymethoxyethylene, polyvinyl alcohol, hydroxyethyl cellulose, carboxymethyl cellulose, carboxyethyl cellulose and polyvinyl pyrrolidone.

The content of the water-soluble polymer and the another surfactant is preferably 5% by mass or less, more preferably 1% by mass or less, and particularly preferably 0.5% by mass or less, based on the abrasive composition upon polishing.

### (Azole Group-Containing Compound)

By blending with one or both of the two kinds of preliminary compositions, an azole group-containing compound having a molecular weight of 300 to 15,000, which has three or more azole groups in the molecule, can be added to the abrasive composition of the present invention.

The azole group-containing compound having a molecular weight of 300 to 15,000, which has three or more azole groups in the molecule, in the present invention is an azole group-containing compound having three or more azole groups in the molecule and can be produced by various methods. Azoles include imidazole, triazole, tetrazole and thiazole, and some of these azoles have a reactive substituent such as a hydroxyl group, a carboxyl group or an amino group. Examples thereof include 4-carboxyl-1H-benzotriazole, 4-hydroxybenzotriazole and 2-aminoimidazole. Among these, a carboxyl group reacts with a polyhydric alcohol or a polyvalent amine to form an ester or an amide, respectively. At this time, a compound having three or more azole groups can be produced by using a tri- or higher polyvalent compound as a polyhydric alcohol or polyvalent amine. Similarly, a compound having three or more azole groups can also be produced by reacting an azole having a hydroxyl group or an amino group with a compound having sites capable of reacting with it.

The azole group-containing compound used in the present invention can also be produced by polymerizing an azole having a vinyl group. Examples of the azole having a vinyl group include 1-vinylimidazole and 2-[3-(2H-benzotriazol-1-yl)-4-hydroxyphenyl]ethyl methacrylate.

Among these azole group-containing compounds, a polymer including azole units having a vinyl group is preferred. This polymer is obtained by polymerizing an azole having a vinyl group. The azole having a vinyl group may be polymerized alone, or may be copolymerized with another vinyl compound.

Specifically, the azole group-containing compound can be synthesized by adjusting the molecular weight per one azole group of the azole group-containing compound within a range from 90 to 300, and particularly preferably from 90 to 200.

Examples of the vinyl compound, which is copolymerizable with the azole having a vinyl group, include acrylic acid, methacrylic acid, methyl acrylate, methyl methacrylate, acrylamide, N-vinylacetamide, N-vinylformamide, acryloylmorpholine, N-vinyl pyrrolidone, vinyl acetate and styrene.

The method for polymerizing such a vinyl compound is usually a method of radical polymerization in an aqueous solution or an organic solvent. Although the polymerization is performed using a radical initiator such as azobisisobutyronitrile, the molecular weight may be adjusted by a chain transfer agent such as dodecylmercaptan, trimethylolpropanetris(3-mercaptopropionate) or an α-methylstyrene dimer.

The molecular weight of a usable polymer may be from 300 to 15,000 in terns of a weight-average molecular weight. The weight-average molecular weight is preferably from 500 to 10,000, more preferably from 2,000 to 8,000, and still more preferably from 4,500 to 6,500.

The content of the azole group-containing compound in abrasive composition used in the present invention may be from 0.001 to 1% by mass, preferably from 0.002 to 0.5% by mass, and more preferably from 0.003 to 0.1% by mass. It is possible to adjust dishing also by the azole group-containing compound.

The abrasive composition of the present invention can be used in any form of an organic solvent composition, an organic solvent/water mixed composition and an aqueous composition. However, taking account of cost and usability, the abrasive composition is preferably in the form of an aqueous solution. Therefore, it is preferred that the azole group-containing compound used in the present invention is also water soluble. In order to produce the abrasive composition of the present invention, two preliminary compositions each having a high concentration are prepared, followed by mixing and, whereby an abrasive composition used for polishing can be prepared. Therefore, the solubility of the azole group-containing compound used in the present invention in water is preferably 0.01% by mass or more, and more preferably 0.03% by mass or more.

It is known that an azole group used in the present invention interacts with metal such as copper, and it is considered that this leads to reduced step height reduction ratio and dishing. The polishing rate of a barrier film made of tantalum or the like can be controlled by the azole group-containing compound used in the present invention, and it is considered that this is useful for reduced erosion characteristics. In contrast, although erosion is reduced by a basic compound such as ethanolamine typically used to similarly control the polishing rate of a barrier film, step height reduction ratio and dishing are increased by the basic compound. It is considered that, according to the present invention, the use of the azole group-containing compound having a molecular weight of 300 to 15,000, which has three or more azole groups, causes complicated action and thus conflicting functions of decreasing step height reduction ratio, dishing and erosion can be achieved at a time. An azole group-containing compound having a molecular weight of more than 15,000, which has three or more azole groups, tends to cause metal residue on the section other than wiring, such as a section of a barrier film, upon polishing of wiring metal, and thus may limit application of a barrier film polishing slurry.

### (Other Components)

The abrasive composition of the present invention can further contain an anticorrosive agent (a protective film-forming agent). When an anticorrosive agent is used, one or both of preliminary compositions (A) and (B) can contain it. Preferred examples of the component, which can be used as the anticorrosive agent, are azoles such as benzimidazole-2-thiol, 2-[2-(benzothiazolyl)]thiopropionic acid, 2-[2-(benzothiazolyl)thiobutyric acid, 2-mercaptobenzothiazole, 1,2,3-triazole, 1,2,4-triazole, 3-amino-1H-1,2,4-triazole, benzotriazole, 1-hydroxybenzotriazole, 1-dihydroxypropylbenzotriazole, 2,3-dicarboxypropylbenzotriazole, 4-hydroxybenzotriazole, 4-carboxyl-1H-benzotriazole, 4-methoxycarbonyl-1H-benzotriazole, 4-butoxycarbonyl-1H-benztriazole, 4-octyloxycarbonyl-1H-benzotriazole, 5-hexylbenzotriazole, N-(1,2,3-benzotriazolyl-1-methyl)-N-(1,2,4-triazolyl-1-methyl)-2-ethylhexylamine, tolyltriazole, naphthotriazole, bis [(1-benzotriazolyl)methyl]phosphonic acid, benzimidazole, and tetrazole, or salts thereof. More preferred examples are benzotriazole, tolyltriazole, hydroxybenzotriazole, carboxybenzotriazole, benzimidazole, tetrazole and quinaldic acid. The content of the anticorrosive agent may be 5% by mass or less, preferably 2% by mass or less, and more preferably 0.5% by mass or less, based on the abrasive composition upon polishing. It is effective for prevention of roughening of the surface of the metal film to incorporate such an anticorrosive agent in the composition.

In the present invention, an alkali can be added to the abrasive composition as long as an adverse influence is not exerted on performances and physical properties thereof. One or both of preliminary compositions (A) and (B) can contain the alkali. The alkali is used for the purpose of maintaining stable polishing performance, or used as a pH adjustor or a buffer agent. Examples of the alkali include ammonia; sodium hydroxide; potassium hydroxide; potassium carbonate; potassium hydrogencarbonate; ammonium hydrogencarbonate; alkylmonoamines such as methylamine, ethylamine, propylamine, isopropylamine, butylamine, isobutylamine, t-butylamine, amylamine, allylamine, 2-ethylhexylamine, cyclohexylamine, benzylamine and furfurylamine; monoamines having a hydroxyl group, such as O-aminophenol, ethanolamine, 3-amino-1-propanol and 2-amino-1-propanol; diamines such as ethylenediamine, diethylenetriamine, triethylenetetramine, tetraethylenepentamine, pentaethylenehexamine, O-phenylenediamine, trimethylenediamine, 2,2-diamino-di-n-propylamine, 2-methyl-2-(2-benzylthioethyl)ethylenediamine, 1,5-diamino-3-pentanol, 1,3-diamino-2-propanol, xylenediamine and bisaminopropyl polyalkylene ether; and polyamines such as polyallylamine and polyethyleneimine. Among these alkalis, ammonia, potassium hydroxide, ethylenediamine and propylenediamine are preferred. The amount of the alkali to be added may be 10% by mass or less, preferably 5% by mass or less, and more preferably 1% by mass, based on the abrasive composition. Some of the alkalis does not have an effect on dishing. However, they are additives which can usually increase dishing.

### (Use of Abrasive Composition)

The abrasive composition used in the present invention is preferably used at a pH within a range from 2 to 12, more preferably from 3 to 11, and still more preferably from 5 to 10. As the reagent for adjusting a pH, the aforementioned inorganic acid, organic acid or alkali can be used.

The abrasive composition used in the present invention can be preferably used at a temperature within a range from 0 to 100°C. Although the temperature is usually preferably at about room temperature, at which the composition is used, the temperature of the abrasive composition can be adjusted for the purpose of adjusting the polishing rate. When the temperature is too low, the polishing rate does not increase. When the temperature is 0°C or lower, the abrasive composition may be frozen. In contrast, when the temperature is high, it is contemplated that side reactions may occur. The temperature is preferably from 10 to 50°C, and more preferably from 15°C to 40°C.

The amount of the abrasive composition used in the present invention to be dropped to a polishing machine is decided depending on the sizes of the polishing machine and a wafer. When an 8 inch wafer (200 mm wafer) is used, the composition can be used at 10 to 1,000 ml/min. The amount of composition dropped is preferably from 50 to 500 ml/min, and more preferably from 100 to 400 ml/min.

Objects to be polished, to which the abrasive composition of the present invention is preferably applied, include metals. Specific examples of preferred metal include aluminum, copper, iron, tungsten, nickel, tantalum, platinum group metal such as ruthenium and platinum, and alloys thereof. A portion of wiring of a multilayer interconnection or a metal film, with which the wiring portion is covered, is particularly preferred object, the metal being filled in depressions of a substrate so as to cover the depressions. More preferably, the composition can be used for copper or a copper alloy, or iron or iron alloy, which forms a wiring portion of a multilayer interconnection. A barrier film may be formed between the wiring metal film and a substrate. In that case, the metal film and the barrier film can be polished together. As the barrier film material, tantalum, a tantalum alloy, tantalum nitride, titanium or a titanium alloy is preferably used. Between a barrier film and an interlayer dielectric film, a cap material or an anti-reflection film may be interposed, the thickness of which is from about several tens to hundreds of nm.

The polishing methods using the abrasive composition of the present invention include a method of polishing a metal film to be polished by relatively moving a polishing platen and a substrate having, for example, a metal film to be polished in a state where the substrate is pushed to an abrasive cloth on the polishing platen while supplying the abrasive composition of the present invention onto the abrasive cloth. As a polishing machine, for example, a conventional polishing machine having a holder for holding a semiconductor substrate and a platen having an abrasive cloth attached thereto can be used. Although it is difficult to define the rotational speed of the polishing platen since it varies depending on the structure and size of the polishing machine, polishing is performed at a rotational speed of from 10 to 500 m/min, preferably from 20 to 300 m/min, and more preferably from 30 to 150 m/min. In order to maintain uniformity of substrate polishing due to rotation of the polishing platen, it is necessary to rotate the substrate. The number of revolutions of the substrate is controlled to nearly the same the number of revolutions as the polishing platen. In order to obtained uniformity, the number of revolutions may be somewhat decreased or increased. The substrate is pushed to the abrasive cloth under a pressure via the holder. The pressure applied can be from 0.1 to 100 KPa. Sine the pressure tends to be low when the rotational speed of the polishing platen is high, it is difficult to define the pressure. However, the pressure is preferably from 0.5 to 80 KPa, and more preferably from 1 to 50 KPa.

As the abrasive cloth, a conventional nonwoven fabric, polyurethane foam or the like can be used. The abrasive cloth is often provided with grooves so as to increase the polishing rate or to facilitate discharge of a slurry. Although an XY groove, a K groove, etc., are known, any groove can be used for the abrasive composition of the present invention. In order to stably perform a polishing process while preventing clogging of the abrasive cloth, the abrasive cloth is dressed using a dresser with diamonds, for which a conventionally known method can be used.

For a method of supplying the abrasive composition of the present invention onto the abrasive cloth on the polishing platen, the abrasive composition is continuously supplied using a pump. At this time, the abrasive composition may be supplied in the form of one liquid containing all components, or the respective preliminary compositions can be supplied using separate lines. When two or more liquids are supplied using separate lines, one liquid prepared therefrom right before the abrasive cloth can be supplied, or the liquids can be supplied onto the abrasive cloth as they are using separate lines and can be mixed while polishing.

Taking account of convenience of handling, such as stability of the liquid, each of preliminary compositions used in the present invention may be divided into plural parts and/or concentrated for transformation or storage. For example, the preliminary composition can be separated into two stock solutions of an oxidizing agent and the other, or three stock solutions in total by dividing the stock solution of the components other than the oxidizing agent into one based on abrasive grain and the other. By using these separated stock solutions in combination, a kit, which will provide a preliminary composition or even an abrasive composition to be used for polishing by mixing the stock solutions and, if necessary, diluting the mixture, may be formed. Further, the preliminary composition may be a concentrated (for example, 2 to 5 times) composition and may be diluted with water or the like upon production of an abrasive composition to a concentration suited for polishing.

By using the abrasive composition produced by the method of the present invention, a substrate having a metal film planarized can be produced. This process will be further explained as a process for forming wiring on a device. First, an interlayer dielectric film on a substrate is provided with grooves and openings, at which wiring is to be formed, and a thin barrier film is formed on the dielectric film. Furthermore, a film of metal, such as copper, for metal wiring is formed by a plating method or the like so as to fill the grooves and openings. This metal film is polished and, if necessary, the barrier film and interlayer dielectric film are further polished for planarization, to thereby produce a substrate having the metal film planarized.

A method for forming wiring in an MRAM using an abrasive composition produced by the method of the present invention will be described below. The metal wiring is composed of a conductor layer made of aluminum or an aluminum alloy, or copper or a copper alloy, and a ferromagnetic layer made of nickel-iron (permalloy) formed so as to surround the conductor layer. If necessary, thin barrier films made of tantalum, tantalum nitride or the like are formed so as to sandwich the ferromagnetic layer. This metal wiring is formed by a damascene process, and excessive conductor layer, ferromagnetic layer and barrier film are removed by planarization with polishing.

The interlayer dielectric film as used herein means a silicon oxide film, an inorganic interlayer dielectric film containing a large amount of silicon, such as hydroxysilsesquioxane (HSQ) or methylsilsesquioxane (MSQ), or an organic interlayer dielectric film such as a film made of benzocyclobutene. It is also possible to use a low dielectric constant interlayer dielectric film of the above material having voids incorporated.

### Examples

The present invention will be described in more detail by way of Examples, but the present invention is not limited thereto.

### [Synthesis Example]

An synthesis Example of an azole group-containing compound having three or more azole groups will be shown below, but the present invention is not limited thereto.

In a 500 ml flask equipped with a thermometer, a stirrer, a nitrogen introducing tube and a reflux condenser tube, 40 g of 2-propanol was charged and heated to a reflux temperature (about 83°C) while stirring under a nitrogen atmosphere. To this were added a solution prepared by dissolving a solution (hereinafter referred to as the monomer solution), which had been prepared by dissolving 46.31 g of 1-vinylimidazole, 43.69 g of N-vinyl pyrrolidone, 1.46 g of α-methylstyrene dimer in 28.5 g of 2-propanol, in 78 g of 2-propanol, and a solution (hereinafter referred to as the initiator solution 1) prepared by dissolving 2.45 g of dimethyl 2,2'-azobis(2-methyl propionate) in 213.55 g of 2-propanol, using a constant rate pump. The monomer solution was added over 4 hours and the initiator solution 1 was added over 7 hours. After the addition of the initiator solution 1, the reaction was continued for one hour, and a solution (hereinafter referred to as the initiator solution 2) prepared by dissolving 0.21 g of dimethyl 2,2'-azobis(2-methyl propionate) in 6.59 g of 2-propanol was then added. After repeating the operation of adding the same initiator solution 2 (additional initiator addition operation) 5 times at an interval of one hour of the reaction, the reaction was continued for 4 hours. After cooling to room temperature, about 380 g of a brown transparent solution was obtained. The brown transparent solution was concentrated by a rotary vacuum evaporator, and the concentrate was repeatedly dissolved in water twice, to thereby replace the solvent of 2-propanol by water. The solution had a solid content of 15% and was used for preparation of a slurry without isolation.

A molecular weight of the synthesized compound (hereinafter sometimes referred to as "compound E") was measured in terms of polyethylene glycol using gel permeation chromatography (GPC). The molecular weight was 5,000.

### (Wafer)

Blanket wafer: Silicone wafer, on which a copper film and a tantalum film (barrier film) were uniformly formed. Patterned wafer: Silicone wafer provided with grooves having a depth of 500 nm, on which a 25 nm thick barrier film of tantalum was formed and a 1,000 nm thick copper film was deposited (see the top drawing of Fig. 1).

### (Polishing of 8 Inch Wafer)

Relative velocity of substrate and polishing platen: 70 m/min
Polishing pad: IC1000/SUBA400 manufactured by Rodel Nitta Company
Abrasive composition supply rate: 200 ml/min

### <Evaluation of Polishing Characteristics>

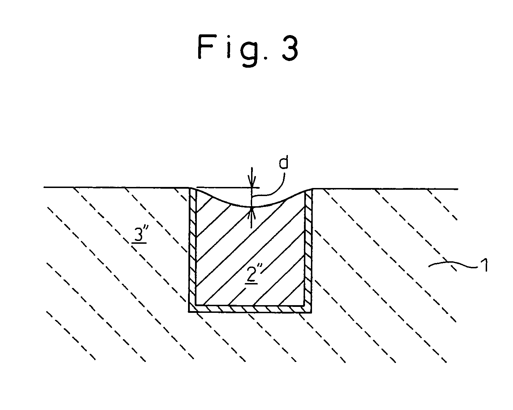

Measurement of step: A stylus-type surface profilometer was used.
Measurement of blanket copper and tantalum film thicknesses: Thicknesses were measured from a sheet resistance.
Measurement of patterned copper film thickness: Thickness was measured from a sheet resistance of a non-patterned copper film in the vicinity of the portion to be evaluated.
Measurement of polishing rate: Thicknesses of a copper film and a barrier film were measured from electrical resistivities before and after polishing and polishing rate was calculated from polishing time.
Polishing of patterned wafer: When Mirra manufactured by Applied Materials, Inc. was used as a polishing machine, an end point was detected by the end point detector of standard equipment and polishing was terminated after over-polishing for 20 seconds.
Evaluation of dishing: As shown in Fig. 3, a step d between a 100 µm space portion 3" and a 100 µm line portion 2" formed in a silicone wafer 1 was evaluated as dishing.

### (Example 1)

Compound E having a molecular weight of 5,000 was used as an azole compound.

Using a polishing machine Mirra manufactured by Applied Materials, Inc., an 8 inch wafer was evaluated. Polishing was performed at a relative velocity of a substrate and a polishing platen of 75 m/min, with an abrasive composition supply rate of 200 ml/min and a pressure of 14 kPa.

A polishing pad IC1000 (k-XY groove) manufactured by Rodel Nitta Company was used. In order to produce an abrasive composition, preliminary compositions with compositions shown in Table 1 were used. For each composition, the component other than the components shown in the table was water. The amount of each component in the table is expressed by % by mass based on the mass of the entire composition including water. Among alkalis used, ammonia was used in the amount enough to give the pH shown in the table. In the table, APS denotes ammonium persulfate, DBS denotes dodecylbenzenesulfonic acid, POE denotes polyoxyethylene secondary alkyl ether phosphate ester, OLA denotes oleic acid, BZI denotes benzimidazole, and PDA denotes propylenediamine. Colloidal silica having a particle diameter of 120 nm was used as silica for abrasive grain.

**Table 1**

| Compositions | Abrasive grain % by mass | Oxidizing agent % by mass | Azole % by mass | Acid % by mass | Surfactant % by mass | Anticorrosive agent % by mass | Alkali | pH |
|---|---|---|---|---|---|---|---|---|
| Composition 1 | Silica 1.5 | APS 1.5 | Compound E 0.05 | Oxalic acid dihydrate 0.7 | DBS 0.07 POE 0.005 OLA 0.01 | BZI 0.005 | Ammonia | 9.3 |
| Composition 2 | Silica 1.5 | APS 1.5 | Compound E 0.05 | Oxalic acid dihydrate 0.7 | DBS 0.07 POE None OLA 0.005 | None | Ammonia | 9.3 |
| Composition 3 | Silica 1.5 | APS 1.5 | Compound E 0.05 | Oxalic acid dihydrate 0.7 | DBS 0.07 POE 0.005 OLA 0.01 | BZI 0.07 | Ammonia | 9.3 |
| Composition 4 | Silica 1.5 | APS 1.5 | Compound E 0.05 | Oxalic acid dihydrate 0.7 | DBS 0.07 POE 0.01 OLA 0.03 | BZI 0.07 | Ammonia | 9.3 |
| Composition 5 | Silica 1.5 | APS 1.5 | Compound E 0.05 | Oxalic acid dihydrate 0.7 | DBS 0.07 POE 0.01 OLA 0.03 | BZI 0.02 | Ammonia PDA 0.08 | 9.4 |
| Composition 6 | Silica 1.5 | APS 1.5 | None | None | None | None | None | 6.5 |
| Composition 7 | Silica 1.5 | APS 2.0 | Compound E 0.05 | Oxalic acid dihydrate 0.7 | DBS 0.07 POE 0.005 OLA 0.01 | BZI 0.005 | Ammonia | 9.4 |

Using one of the compositions shown in Table 1 as preliminary composition (A), and another as preliminary composition (B), abrasive compositions 1 to 15 as shown in Table 2 were prepared. Abrasive compositions 1, 5 and 9 using only a single preliminary mixture represent Control Examples. For abrasive compositions 1 to 4, composition 1 containing the abrasive grain, oxidizing agent, organic acid, surfactant, azole compound and anticorrosive agent was used as preliminary composition (A), and composition 2 containing the abrasive grain, oxidizing agent, organic acid, surfactant and azole compound was used as preliminary composition (B), and they were mixed for polishing. Dishing could vary from 11 nm in Control Example 1 to 83 nm. Within this range, the polishing rate did not largely vary. For abrasive compositions 5 to 8, composition 3 containing a larger amount of anticorrosive agent than that of composition 1 was used as preliminary composition (A), and composition 2 was used as preliminary composition (B). In these abrasive compositions, although small dishing was observed compared with the abrasive compositions 1 to 4, it was possible to control dishing from 4 nm in Control Example 4 to 125 nm. For abrasive compositions 9 to 11, composition 4 containing the abrasive grain, oxidizing agent, organic acid, surfactant, azole compound and anticorrosive agent was used as preliminary composition (A), and composition 5 which was a composition having propylenediamine, as an alkali, additionally added to composition 4 as preliminary composition (B). Dishing could vary from 14 nm in Control Example 9 to 71 nm. In Examples 14 and 15, composition 1 was used as preliminary composition (A), and composition 7 containing an increased amount of ammonium persulfate, which was the oxidizing agent in composition 1, compared to the amount thereof in composition 1 was used as preliminary composition (B). It was showed that dishing can be controlled by varying the concentration of oxidizing agent in the entire abrasive composition prepared by mixing two preliminary compositions when compared with Control Example 1. In Examples 12 and 13, composition 1 was used as preliminary composition (A), and composition 6, which was a composition containing only the oxidizing agent and abrasive grain of composition 1, was used as preliminary composition (B). In effect, this involves a method in which the components other than the abrasive grain and oxidizing agent are diluted with water. In contrast to Control Example 1, dishing is also controlled by this method. The combination of preliminary compositions 1 and 2, the combination of preliminary compositions 3 and 2 and the combination of preliminary compositions 4 and 5, in which there is a comparatively linear relation between a mixing ratio of the preliminary compositions and a dishing amount, are particularly preferred since they allow easy control of dishing.

**Table 2**

| Abrasive compositions | Composition (% by mass) | | Cu (blanket) polishing rate | Dishing |
|---|---|---|---|---|
| | Preliminary composition A | Preliminary composition B | | |
| 1 (Control Example) | Composition 1 100% | | 1040 nm/min | 11 nm |
| 2 (Example) | Composition 1 60% | Composition 2 40% | 1190 nm/min | 26 nm |
| 3 (Example) | Composition 1 40% | Composition 2 60% | 1190 nm/min | 47 nm |
| 4 (Example) | Composition 1 20% | Composition 2 80% | 1270 nm/min | 83 nm |
| 5 (Control Example) | Composition 3 100% | | 930 nm/min | 4 nm |
| 6 (Example) | Composition 3 60% | Composition 2 40 % | 1110 nm/min | 28 nm |
| 7 (Example) | Composition 3 40% | Composition 2 60% | 1120 nm/min | 60 nm |
| 8 (Example) | Composition 3 20% | Composition 2 80% | 1270 nm/min | 125 nm |
| 9 (Control Example) | Composition 4 100% | | 1020 nm/min | 14 nm |
| 10 (Example) | Composition 4 75% | Composition 5 25% | 930 nm/min | 51 nm |
| 11 (Example) | Composition 4 60% | Composition 5 40% | 880 nm/min | 71 nm |
| 12 (Example) | Composition 1 70% (Preliminary composition A') | Composition 6 30% (Preliminary composition B') | 930 nm/min | 23 nm |
| 13 (Example) | Composition 1 50% (Preliminary composition A') | Composition 6 50% (Preliminary composition B') | 870 nm/min | 110 nm |
| 14 (Example) | Composition 1 50% | Composition 7 50% | 960 nm/min | 7 nm |
| 15 (Control Example) | Composition 1 | Composition 7 100 % | 1100 nm/min | 46 nm |

### (Example 2)

Compound E having a molecular weight of 5,000 was used as an azole compound.

Using a polishing machine Mirra manufactured by Applied Materials, Inc., an 8 inch wafer was evaluated. Polishing was performed at a relative velocity of a substrate and a polishing platen of 75 m/min, with an abrasive composition supply rate of 200 ml/min, and a pressure of 14 kPa.

A polishing pad IC1000 (k-XY groove) manufactured by Rodel Nitta Company was used. In order to produce an abrasive composition, preliminary compositions with compositions shown in Table 3 were used. For each composition, the component other than the components shown in the table was water. The amount of each component in the table is expressed by % by mass based on the mass of the entire composition including water. Ammonia was used in the amount enough to give the pH shown in the table. In the table, APS denotes ammonium persulfate, DBS denotes dodecylbenzenesulfonic acid, POE denotes polyoxyethylene secondary alkyl ether phosphate ester, OLA denotes oleic acid, and BZI denotes benzimidazole. Colloidal silica having a particle diameter of 120 nm was used as silica for abrasive grain.

**Table 3**

| Compositions | Abrasive grain % by mass | Oxidizing agent % by mass | Azole % by mass | Acid % by mass | Surfactant % by mass | Anticorrosive agent % by mass | Alkali | pH |
|---|---|---|---|---|---|---|---|---|
| Composition 8 | Silica 1.5 | APS 1.5 | Compound E 0.02 | Oxalic acid dihydrate 0.7 | DBS 0.07 POE 0.01 OLA 0.03 | BZI 0.005 | Ammonia | 9.3 |
| Composition 9 | Silica 1.5 | APS 1.5 | Compound E 0.07 | Oxalic acid dihydrate 0.7 | DBS 0.07 POE 0.01 OLA 0.03 | BZI 0.005 | Ammonia | 9.3 |
| Composition 10 | Silica 1.5 | APS 1.5 | Compound E 0.02 | Oxalic acid dihydrate 0.7 | DBS 0.07 POE 0.01 OLA 0.03 | BZI 0.007 | Ammonia | 9.3 |
| Composition 11 | Silica 1.5 | APS 1.5 | Compound E 0.07 | Oxalic acid dihydrate 0.7 | DBS 0.07 POE 0.01 OLA 0.03 | BZI 0.007 | Ammonia | 9.3 |

Using one of the compositions shown in Table 3 as preliminary composition (A), and another as preliminary composition (B), abrasive compositions 16 to 25 as shown in Table 4 were prepared. Abrasive compositions 16, 20, 21 and 25 using only a single preliminary mixture represent Control Examples. For abrasive compositions 16 to 20, composition 8 containing the abrasive grain, oxidizing agent, organic acid, surfactant, anticorrosive agent and compound having three or more azole groups was used as preliminary composition (A), and composition 9, which was a composition having the amount of compound having three or more azole increased from 0.02% by mass of composition 8 to 0.07% by mass, was used as preliminary composition (B). In abrasive compositions 21 to 25, compositions 10 and 11 respectively having the amounts of anticorrosive agent added increased from those in compositions 8 and 9, were used as preliminary compositions (A) and (B), respectively. In both cases, dishing was controllable.

**Table 4**

| Abrasive compositions | Composition (% by mass) | | Cu (blanket) polishing rate | Dishing |
|---|---|---|---|---|
| | Preliminary composition A | Preliminary composition B | | |
| 16 (Control Example) | Composition 8 100% | | 1120 nm/min | 32 nm |
| 17 (Example) | Composition 8 60% | Composition 11 40% | 1030 nm/min | 27 nm |
| 18 (Example) | Composition 8 40% | Composition 11 60% | 1020 nm/min | 29 nm |
| 19 (Example) | Composition 8 20% | Composition 11 80% | 1020 nm/min | 42 nm |
| 20 (Control Example) | | Composition 11 100% | 1010 nm/min | 63 nm |
| 21 (Control Example) | Composition 10 100% | | 990 nm/min | 8 nm |
| 22 (Example) | Composition 10 60% | Composition 11 40% | 950 nm/min | 15 nm |
| 23 (Example) | Composition 10 40% | Composition 11 60% | 960 nm/min | 34 nm |
| 24 (Example) | Composition 10 20% | Composition 11 80% | 930 nm/min | 35 nm |
| 25 (Control Example) | | Composition 11 100% | 930 nm/min | 42 nm |

### (Example 3)

Compound E having a molecular weight of 5,000 was used as an azole compound.

Using a polishing machine Mirra manufactured by Applied Materials, Inc., an 8 inch wafer was evaluated. Polishing was performed at a relative velocity of a substrate and a polishing platen of 75 m/min, with an abrasive composition supply rate of 200 ml/min, and a pressure of 14 kPa.

A polishing pad IC1000 (k-XY groove) manufactured by Rodel Nitta Company was used. In order to produce an abrasive composition, preliminary compositions with compositions shown in Table 5 were used. For each composition, the component other than the components shown in the table was water. The amount of each component in the table is expressed by % by mass based on the mass of the entire composition including water. In the table, APS denotes ammonium persulfate, DBS denotes dodecylbenzenesulfonic acid, POE denotes polyoxyethylene secondary alkyl ether phosphate ester, OLA denotes oleic acid, and BZI denotes benzimidazole. Colloidal silica used as abrasive grain had a particle diameter of 120 nm.

**Table 5**

| Compositions | Abrasive grain % by mass | Azole % by mass | Acid % by mass | Oxidizing agent % by mass | Surfactant % by mass | Anticorrosive agent % by mass | Alkali % by mass | pH |
|---|---|---|---|---|---|---|---|---|
| Composition 12 | Colloidal silica 1.5 | Compound E 0.04 | Oxalic acid dihydrate 0.7 | APS 1.5 | DBS 0.07 POE 0.01 OLA 0.03 | BZI 0.005 | Ammonia 0.32 | 9.2 |
| Composition 13 | Colloidal silica 1.5 | Compound E 0.08 | Oxalic acid dihydrate 0.7 | APS 1.5 | DBS 0.07 POE 0.01 OLA 0.03 | BZI 0.005 | Ammonia 0.32 | 9.3 |
| Composition 14 | Colloidal silica 2.0 | Compound E 0.04 | Oxalic acid dihydrate 0.7 | APS 1.5 | DBS 0.07 POE 0.01 OLA 0.03 | BZI 0.005 | Ammonia 0.32 | 9.2 |
| Composition 15 | Colloidal silica 2.0 | Compound E 0.08 | Oxalic acid dihydrate 0.7 | APS 1.5 | DBS 0.07 POE 0.01 OLA 0.03 | BZI 0.005 | Ammonia 0.32 | 9.3 |

Using one of the compositions shown in Table 5 as preliminary composition A, and another as preliminary composition B, abrasive compositions 26 to 35 as shown in Table 6 were prepared. Abrasive compositions 26, 30, 31 and 35 using only a single preliminary mixture represent Control Examples. For abrasive compositions 26 to 30, composition 12 containing the abrasive grain, oxidizing agent, organic acid, surfactant, anticorrosive agent and compound having three or more azole groups was used as preliminary composition (A), and composition 13, which was a composition having the amount of compound having three or more azole increased from 0.04% by mass of composition 12 to 0.08% by mass, was used as preliminary composition (B). In abrasive compositions 31 to 35, compositions 14 and 15 respectively having the amounts of abrasive grain added increased from those in compositions 12 and 13, were used as preliminary compositions (A) and (B), respectively. In both cases, dishing was controllable. It was shown that the higher the amount of colloidal silica, the larger the dishing, and dishing is controllable by the amount of colloidal silica as the abrasive grain.

**Table 6**

| Abrasive compositions | Composition (% by mass) | | Cu (blanket) polishing rate | Dishing |
|---|---|---|---|---|
| | Preliminary composition A | Preliminary composition B | | |
| 26 (Control Example) | Composition 12 100% | | 1060 nm/min | 10 nm |
| 27 (Example) | Composition 12 75% | Composition 13 25% | 1020 nm/min | 21 nm |
| 28 (Example) | Composition 12 50% | Composition 13 50% | 1010 nm/min | 22 nm |
| 29 (Example) | Composition 12 25% | Composition 13 75% | 990 nm/min | 26 nm |
| 30 (Control Example) | | Composition 13 100% | 1030 nm/min | 119 nm |
| 31 (Control Example) | Composition 14 100% | | 1030 nm/min | 17 nm |
| 32 (Example) | Composition 14 75% | Composition 15 25% | 980 nm/min | 16 nm |
| 33 (Example) | Composition 14 50% | Composition 15 50% | 960 nm/min | 15 nm |
| 34 (Example) | Composition 14 25% | Composition 15 75% | 960 nm/min | 64 nm |
| 35 (Control Example) | | Composition 15 100% | 1010 nm/min | 147 nm |

### (Example 4)

Using a polishing machine Mirra manufactured by Applied Materials, Inc., an 8 inch wafer was evaluated. Polishing was performed at a relative velocity of a substrate and a polishing platen of 75 m/min, with an abrasive composition supply rate of 150 ml/min, and a pressure of 14 kPa.

A polishing pad IC1000 (k-XY groove) manufactured by Rodel Nitta Company was used. Abrasive compositions shown in Table 8 were prepared by using the preliminary compositions with compositions shown in Table 7. For each composition, the component other than the components shown in the table is water. The amount of each component in the table is expressed by % by mass based on the mass of the entire composition including water. Ammonia was used in the amount enough to give the pH shown in the table. In the table, APS denotes ammonium persulfate, DBS denotes dodecylbenzenesulfonic acid, and OLA denotes oleic acid. Colloidal silica having a particle diameter of 120 nm was used as silica for abrasive grain.

**Table 7**

| Compositions | Abrasive grain % by mass | Oxidizing agent % by mass | Azole % by mass | Acid % by mass | Surfactant % by mass | Anticorrosive agent % by mass | Alkali | PH |
|---|---|---|---|---|---|---|---|---|
| Composition 16 | Silica 2.0 | APS 1.5 | None | Oxalic acid dihydrate 0.5 | DBS 0.21 OLA 0.005 | None | Ammonia | 9.3 |
| Composition 17 | Silica 2.0 | APS 1.5 | None | Oxalic acid dihydrate 0.5 | DBS 0.07 OLA 0.005 | None | Ammonia | 9.3 |

Compositions 16 and 17 contain the abrasive grain, oxidizing agent, acid (organic acid) and surfactant, and preliminary composition (A) and preliminary composition (B) are different in amount of surfactant DBS. As the amount of DBS decreases, dishing decreases and can be controlled.

**Table 8**

| Abrasive compositions | Composition (% by mass) | | Cu (blanket) polishing rate | Dishing |
|---|---|---|---|---|
| | Preliminary composition A | Preliminary composition B | | |
| 36 (Control Example) | Composition 16 100% | | 881 nm/min | 97 nm |
| 37 (Example) | Composition 16 50% | Composition 17 50% | 984 nm/min | 137 nm |

## Claims

1. A method for producing plural kinds of abrasive compositions different in dishing amount, for polishing a metal film filled in depressions of a substrate so as to cover the depressions, or a metal film filled in depressions of a substrate having a barrier metal film formed thereon, so as to cover the depressions, which comprises mixing two kinds of preliminary compositions (A) and (B) having different compositions in different mixing ratios to thereby produce the plural kinds of abrasive compositions, wherein a composition containing (a) an abrasive grain, (b) an oxidizing agent, (c) one or more acids selected from the group consisting of amino acids, organic acids and inorganic acids, and (d) a surfactant, is used as the preliminary composition (A); and a composition containing (a) an abrasive grain and (b) an oxidizing agent is used as the preliminary composition (B).

2. The method for producing plural kinds of abrasive compositions according to claim 1, wherein the preliminary composition (B) further contains (c) one or more acids selected from the group consisting of amino acids, organic acids and inorganic acids and (d) a surfactant, and at least one of (a), (b), (c) and (d) in the preliminary composition (A) has a different concentration from that in the preliminary composition (B).

3. The method for producing plural kinds of abrasive compositions according to claim 2, wherein the concentration of the abrasive grain (a) of the preliminary composition (A) is higher than that of the preliminary composition (B).

4. The method for producing plural kinds of abrasive compositions according to claim 2, wherein the concentration of the oxidizing agent (b) of the preliminary composition (A) is lower than that of the preliminary composition (B).

5. The method for producing plural kinds of abrasive compositions according to claim 2, wherein the concentration of one or more kinds of acids (c) selected from the group consisting of amino acids, organic acids and inorganic acids of the preliminary composition (A) is lower than that of the preliminary composition (B).

6. The method for producing plural kinds of abrasive compositions according to claim 2, wherein the concentration of the surfactant (d) of the preliminary composition (A) is higher than that of the preliminary composition (B).

7. The method for producing plural kinds of abrasive compositions according to claim 1, wherein one or both of the preliminary compositions (A) and (B) further contain an azole group-containing compound having a molecular weight of 300 to 15,000, which has three or more azole groups in the molecule.

8. The method for producing plural kinds of abrasive compositions according to claim 7, wherein both of the preliminary compositions (A) and (B) contain the azole group-containing compound and the concentration of the azole group-containing compound of the preliminary composition (A) is lower than that of the preliminary composition (B).

9. The method for producing plural kinds of abrasive compositions according to claim 1, wherein one or both of the preliminary compositions (A) and (B) further contain an anticorrosive agent.

10. The method for producing plural kinds of abrasive compositions according to claim 9, wherein the anticorrosive agent is benzotriazole, tolyltriazole, hydroxybenzotriazole, carboxybenzotriazole, benzimidazole, tetrazole or quinaldic acid.

11. The method for producing plural kinds of abrasive compositions according to claim 9 or 10, wherein both of preliminary compositions (A) and (B) contain the anticorrosive agent and the concentration of the anticorrosive agent of the preliminary composition (A) is higher than that of the preliminary composition (B).

12. The method for producing plural kinds of abrasive compositions according to claim 1, wherein one or both of the preliminary compositions (A) and (B) further contain(s) an alkali.

13. The method for producing plural kinds of abrasive compositions according to claim 12, wherein the alkali is one or more members selected from the group consisting of ammonia, ethylenediamine and propylenediamine.

14. The method for producing plural kinds of abrasive compositions according to claim 12 or 13, wherein both of preliminary compositions (A) and (B) contain the alkali and the alkali concentration of the preliminary composition (A) is lower than that of the preliminary composition (B).

15. The method for producing plural kinds of abrasive compositions according to claim 1, wherein the pH of an abrasive composition to be produced is from 5 to 11.

16. The method for producing plural kinds of abrasive compositions according to claim 1, wherein the surfactant is one or more members selected from the group consisting of alkylaromatic sulfonic acids having 8 or more carbon atoms, phosphate esters having an alkyl group of 8 or more carbon atoms and fatty acids having an alkyl group of 8 or more carbon atoms.

17. The method for producing plural kinds of abrasive compositions according to claim 1, wherein the concentration of the abrasive grain (a) is 0.01 to 30% by mass based on the abrasive composition upon polishing.

18. The method for producing plural kinds of abrasive compositions according to claim 1, wherein the concentration of the oxidizing agent (b) is from 0.01 to 30% by mass based on the abrasive composition upon polishing.

19. The method for producing plural kinds of abrasive compositions according to claim 1, wherein the concentration of the acid (c) is from 0.01 to 10% by mass based on the abrasive composition upon polishing.

20. The method for producing plural kinds of abrasive compositions according to claim 1, wherein the concentration of the surfactant (d) is 5% by mass or less based on the abrasive composition upon polishing.

21. A method for polishing a substrate, which comprises producing abrasive compositions by the method according to claim 1 and planarization is performed while adjusting a dishing amount of a substrate by polishing the substrate using the abrasive compositions.

22. The method for polishing a substrate according to claim 21, wherein the temperature of the abrasive composition is from 30°C to 50°C.

23. The method for polishing a substrate according to claim 21, wherein the metal film is made of copper or a copper-containing alloy.

24. The method for polishing a substrate according to claim 21, wherein the barrier metal film is made of tantalum or a tantalum alloy.

25. A method for producing a substrate having a dishing amount within a range from 1 to 300 nm, which comprises the step of polishing a substrate by the polishing method according to claim 21.
